# EUROPEAN PATENT APPLICATION

(11) **EP 4 435 437 A1**
(43) Date of publication of application: **25.09.2024**
(21) Application number: 23162962.7
(22) Date of filing: 20.03.2023
(51) Int. Cl.: G01R 15/20

(54) **CURRENT TRANSDUCER FOR MEASURING RESIDUAL CURRENTS**

(71) Applicant: LEM International SA, 1217 Meyrin (CH)
(72) Inventor: TROMBERT, Stéphan, 74320 LESCHAUX (FR)
(74) Representative: reuteler & cie SA

(57) **Abstract**

A current transducer (1) for measuring a residual current, comprising a plurality of primary conductors (2, 2a, 2b, 2c), a magnetic core (3) having at least one air gap (13), at least one field sensor (4) positioned within said at least one air gap (13), and a housing (9) enclosing at least a portion of the primary conductors, magnetic core and magnetic field sensor, each primary conductor extending between first and second connection terminals (61a, 61b, 62a, 62b, 63a, 63b) and having a center section (7a, 7b, 7c) interconnecting the first and second connection terminals, the center section extending through a primary conductor passage (10) surrounded by the magnetic core (3), center sections of the primary conductors arranged in an overlapping stacked relationship separated by insulating layers, the center sections extending along a primary conductor center line (***A***) extending through the primary conductor passage (10). At least a first primary conductor of said plurality of primary conductors comprises a first connection terminal (61a) positioned at a non-null distance from said center line (***A***) and the second connection terminal (61b) thereof being positioned at a non-null distance from said center line (***A***) on a second side of the center line opposite the first side of the center line, and at least a second primary conductor of said plurality of primary conductors having said first connection terminals (63a) separated from the center line at a non-null distance on said second side and having a second said connection terminal (63b) separated from the center line by a non-null distance on the first side of the center line.

## Description

*T*he present invention relates to a current transducer for measuring residual currents.

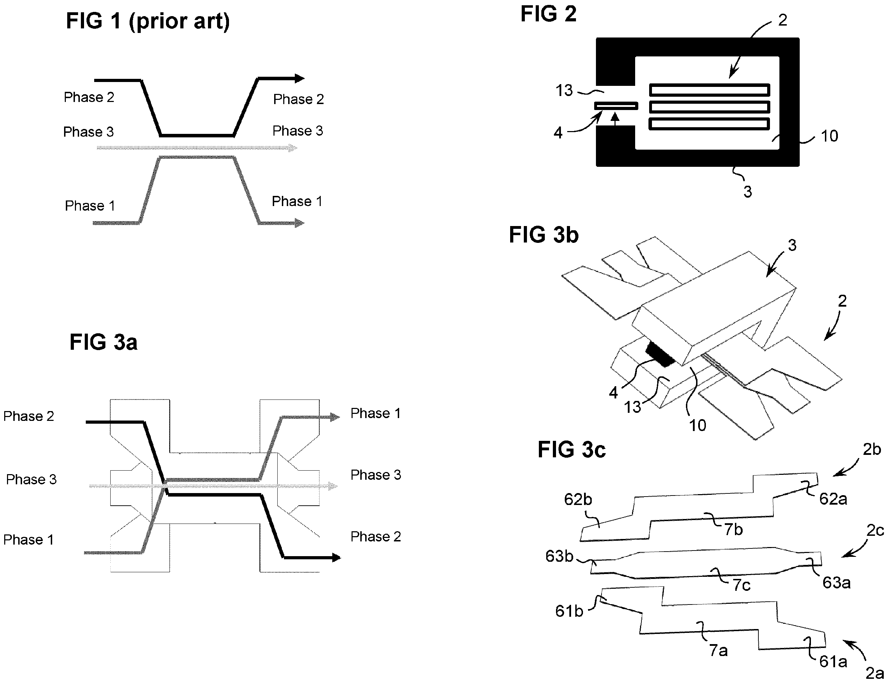

Residual current sensors are usually employed to measure leakage currents in a conductor system. Referring to figures 1 and 2, a conductor system with a set of *N* electrical primary conductors (in this example three) through which flow primary currents, each generating a magnetic field that is concentrated in a magnetic core of the transducer surrounding the primary conductors. This magnetic field is measured by one or more magnetic field transducers in one or more airgaps of the magnetic core. The measured magnetic field is the image of the sum of the *N* currents, which in a system that has supply and return currents in a closed circuit, should be zero amperes (0A). If the measured sum of currents is not equal to 0A, this means that one or several conductors are encountering leakages.

In the situation where there are no leakage currents, the sum of the *N* currents should be 0A because the magnetic fields generated by each primary current of each of the *N* primary conductors should compensate each other by superposition, the fields being concentrated in the magnetic core. However, in practice, this is not the case due to dipolar fields and mechanical asymmetries, whereby the sum of currents that is measured is not zero and may reach an amplitude that disturbs the actual measurement of leakage currents.

The capacity of a transducer to avoid generation of non-null sums due to the aforementioned disturbances is sometimes referred to as Common Mode Rejection (CMR).

To mitigate the effects of the generation of non-null sums described above, and increase CMR, it is known to use very high permeability magnetic cores. Such magnetic cores are however expensive and require specific materials with reduced availability.

In view of the foregoing, it is an object of the invention to provide a current transducer for measuring residual currents that is economical, yet is accurate, in particular having a high Common Mode Rejection.

It is advantageous to provide a current transducer for measuring residual currents that is very compact.

It is advantageous to provide a current transducer for measuring residual currents that is lightweight.

It is advantageous to provide a current transducer for measuring residual currents that is easy to assemble.

It is advantageous to provide a current transducer for measuring residual currents that may be assembled with a circuit board.

A more specific object of the invention for certain applications, is to provide a current transducer for measuring residual currents that may be integrated with a circuit board for multiphase applications, for instance multiphase inverter applications.

Objects of the invention have been achieved by providing a system according to claim 1.

Dependent claims set out various advantageous features of embodiments of the invention.

Disclosed herein is a current transducer for measuring a residual current, comprising a plurality of primary conductors, a magnetic core having at least one air gap, at least one field sensor positioned within said at least one air gap, and a housing enclosing at least a portion of the primary conductors, magnetic core and magnetic field sensor, each primary conductor extending between first and second connection terminals and having a center section interconnecting the first and second connection terminals, the center section extending through a primary conductor passage surrounded by the magnetic core, center sections of the primary conductors arranged in an overlapping stacked relationship separated by insulating layers, the center sections extending along a primary conductor center line (A) extending through the primary conductor passage.

At least a first primary conductor of said plurality of primary conductors comprises a first connection terminal positioned at a non-null distance from said center line (A) and the second connection terminal thereof being positioned at a non-null distance from said center line (A) on a second side of the center line opposite the first side of the center line, and at least a second primary conductor of said plurality of primary conductors having said first connection terminals separated from the center line at a non-null distance on said second side and having a second said connection terminal separated from the center line by a non-null distance on the first side of the center line.

In an advantageous embodiment, the current transducer further comprises a third primary conductor of said plurality of primary conductors, said third primary conductor having said first and second connection terminals and said center section forming a straight primary conductor aligned and centered on the center line (A).

In an advantageous embodiment, there are only three primary conductors for connection to a three-phase conduction system.

In an advantageous embodiment, at least said first and second primary conductors comprise a plurality of slots comprising at least a first slot extending into the center sections from a first lateral side of the center sections, and at least a second slot extending into the center sections from a second lateral side of the center section opposed to the first lateral side, arranged such that a primary current flowing between the first and second connection terminals of said at least first and second primary conductors flows through the center sections in a meandering path.

In an advantageous embodiment, there is at least a third slot extending from the first lateral side of the center section transversally into the center section, the first and third slots arranged in a spaced apart relationship from the first slot.

In an advantageous embodiment, there are three said slots, two extending transversely from the first lateral side and one extending transversely from the second lateral side, positioned substantially centrally between the first and third slots.

In an advantageous embodiment, the slots extend from the respective lateral side along a length (W1, W2) in a range of 40% to 70% of a width (W) of the primary conductor center section between the first lateral side to the second opposed lateral side.

In an advantageous embodiment, the slots are substantially thin straight slits.

In an advantageous embodiment, at least said first and second primary conductors comprising slots have said slots arranged in a stacked overlapping and aligned relationship.

In an advantageous embodiment, the current transducer further comprises a circuit board, the magnetic field sensor being electrically connected to secondary conductor tracks on said circuit board, and the primary conductors provided as conductive circuit traces on different layers of the circuit board.

In an advantageous embodiment, the magnetic field sensor is provided in the form of an ASIC chip, the ASIC chip mounted within an orifice formed through the circuit board, or with a major surface of the ASIC chip mounted flat against an outer surface of the circuit board.

In an advantageous embodiment, the connection terminals of the primary conductors and connection terminals on the circuit board connected to the magnetic field sensor, are in the form of conductive pads or plated through-holes formed on the circuit board for connection to conductors of an external circuit.

In an advantageous embodiment, the housing comprises a base and a cover assembled around the magnetic core, magnetic field sensor and a portion of the primary conductors, the base and cover being assembled together on opposite sides of the circuit board.

In an advantageous embodiment, the magnetic core is in the form of a flat strip of soft magnetic material bent around to form the magnetic circuit, the ends of the magnetic core strip forming open end extensions bent from an end branch of the magnetic core such that the open end extensions are arranged parallel to the circuit board and are mounted against opposite sides of the circuit board.

In an advantageous embodiment, the magnetic core is in the form of a flat strip of soft magnetic material bent around to form the magnetic circuit, the strip of soft magnetic material having a thickness T to width W ratio T/W less than 0.3, preferably less than 0.2, and greater than 0.1, the width being measured in a direction orthogonal to the primary conductor center line (A).

Further advantageous features of the invention will be apparent from the following detailed description of embodiments of the invention and the accompanying illustrations.

### Brief description of the figures

Figure 1 is a simplified schematic representation of a three-phase primary conductor arrangement of a current transducer for measuring residual currents according to the prior art;
Figure 2 is a simplified schematic cross-sectional representation of a current transducer for measuring residual currents;
Figure 3a illustrates a primary conductor arrangement of a three-phase current transducer for measuring residual currents according to an embodiment of the invention;
Figure 3b is a simplified perspective view of a current transducer (without housing) for measuring residual currents according to an embodiment of the invention;
Figure 3c is an exploded view of a primary conductor arrangement of the embodiment of figure 3b;
Figure 4a is a view similar to figure 3a of another embodiment of the invention;
Figure 4b is a perspective view of the embodiment of figure 4a, with an overmolded housing schematically represented in transparency;
Figures 5 a to d schematically illustrate variants of primary conductors of a current transducer for measuring residual currents according to embodiment; of the invention;
Figure 6a is a perspective view of a current transducer for measuring residual currents according to an embodiment of the invention;
Figure 6b is an exploded view of the embodiment of figure 6a;
Figure 6c is cross-sectional view through lines 6c-6c of figure 6a;
Figure 7 is a plot of Common Mode Rejection versus magnetic core permeability of a prior art current transducer and a current transducer according to embodiments of the invention;

Referring to the figures, a current transducer 1 for measuring residual currents, according to embodiments of the invention comprises a plurality of primary conductors 2, a magnetic core 3 surrounding a primary conductor passage 10 through which the primary conductors 2 extend, at least one magnetic field sensor 4 positioned in at least one air gap 13 formed between open ends of the magnetic core, and an insulating housing 9 lodging at least partially the primary conductors, magnetic core, and magnetic field sensor.

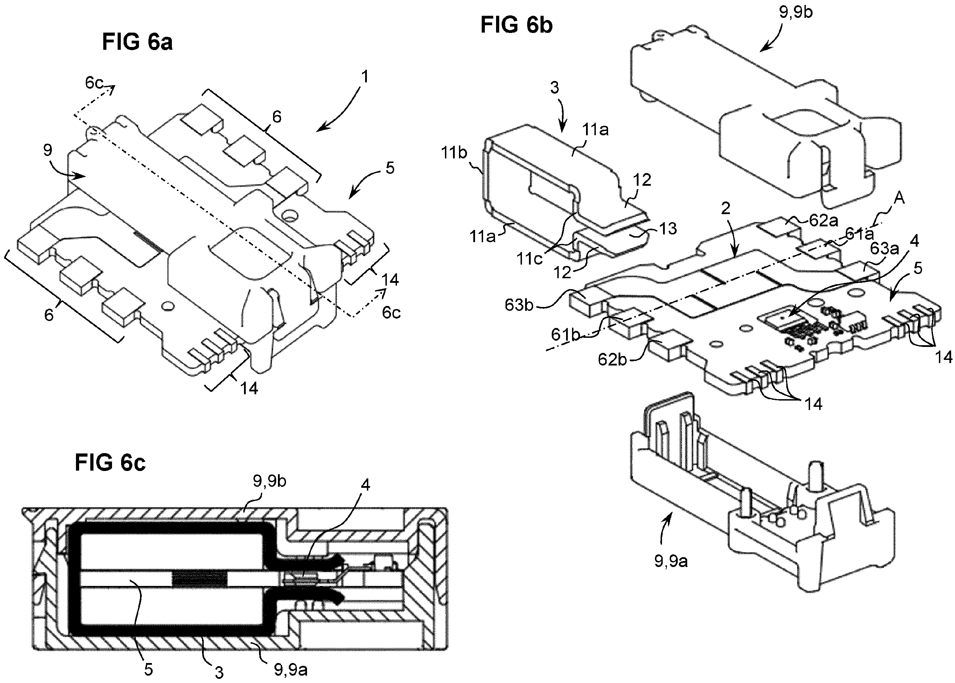

In an embodiment as illustrated in figures 6a to 6c, the current transducer may further comprise a circuit board 5 to which the magnetic field sensor is electrically connected. The primary conductors 2 may further be formed as conductive tracks in the circuit board, the different primary conductors being formed in different layers of the circuit board, separated by insulating layers of the circuit board. Forming conductive tracks in different layers of a circuit board is *per se* well-known in the art of circuit boards. Further electrical components may be mounted on the circuit board, for instance for filtering or signal processing of measurement or power signals to and from the magnetic field sensor. The circuit board 5 may advantageously present connection terminals 6 for connecting the primary conductors 2 to external circuitry, and connection terminals 14 for connection of secondary conductors carrying measurement and power signals to and from the magnetic field sensor 4.

The magnetic core 3 comprises branches 11a, 11b, 11c that surround the primary conductor passage 10 and in the illustrated example comprises a single air gap 13 formed between open end extensions 12 extending from the end branches 11c.

The magnetic core in the embodiment of figures 6a to 6c may advantageously be made of a strip of soft magnetic material that is stamped out of a sheet of material and bent into a substantially rectangular shape surrounding the primary conductor passage 10 whereby the open end extensions 12 of the magnetic core that form the air gap are bent out of the end branches 11c from which they are attached and extend such that the plane of the sheet material of the open end extensions 12 is substantially parallel to the circuit board 5. This allows the open end extensions 12 to overlay the magnetic field sensor 4 which is in a form of an ASIC (application specific integrated circuit) chip, that is mounted with its major surface parallel to the circuit board. The ASIC chip providing the magnetic field sensor 4 may be mounted on top of and lying against an outer surface of the circuit board, or as illustrated in figure 6b, positioned within an orifice 17 of the circuit board. The latter arrangement allows the air gap 13 to be as small as possible, to improve the magnetic coupling of the magnetic field sensor 8 to the magnetic circuit formed by the magnetic core 3.

In an embodiment, the ASIC chip forming the magnetic field sensor 4, may have a thickness that is equal or less than the thickness of the circuit board 5 such that the open end extensions 12 of the magnetic core 3 may lie against opposed outer surfaces of the circuit board, the air gap being defined by the thickness of the circuit board.

The open end extensions 12 may be welded, soldered or clamped against the opposed outer surfaces of the circuit board 5 in order to mechanically secure the magnetic core to the circuit board and define the size of the air gap 13.

The housing 9 may comprise first and second components, for instance in a form of a base 9a and cover 9b that are fixed together around the magnetic core 3 and a portion of the circuit board 5 and magnetic field sensor 4 mounted thereon, the housing 9 having the connection terminals 6 of the primary conductors 2 and connection terminals 14 of the secondary conductors connected to the magnetic field sensor 4 accessible for connection to external circuitry to which the current transducer 1 is mounted and connected.

Other arrangements may however be provided within the scope of the invention according to *per se* known techniques, for instance the connection ends of the primary and secondary conductors may be provided in a connector for pluggable connection to a complementary external connector. In the latter arrangement, the primary conductors, magnetic core, magnetic field sensor and the circuit board may be fully lodged and encased within an insulating housing.

The insulating housing may be assembled, or molded over the magnetic core, magnetic field sensor 4 and primary conductors partially or completely except for the provision of a connector presenting terminals for connection to the primary and secondary conductors.

In the application illustrated in enclosed figures, a three-phase primary conductor system is illustrated, for instance for an inverter, for instance for connection to a photovoltaic system.

In embodiments within the scope of the invention, there may however be two primary conductors, or more than three primary conductors, that are stacked and insulatingly separated, for measurement of a residual current. The principles of the present invention remain the same whether there are two, three, four or more primary conductors stacked and insulatingly separated from each other, for measurement of a residual current.

For the purposes of describing the present invention, a three-phase system is illustrated and discussed, this being one of the more widely used conduction systems in many applications.

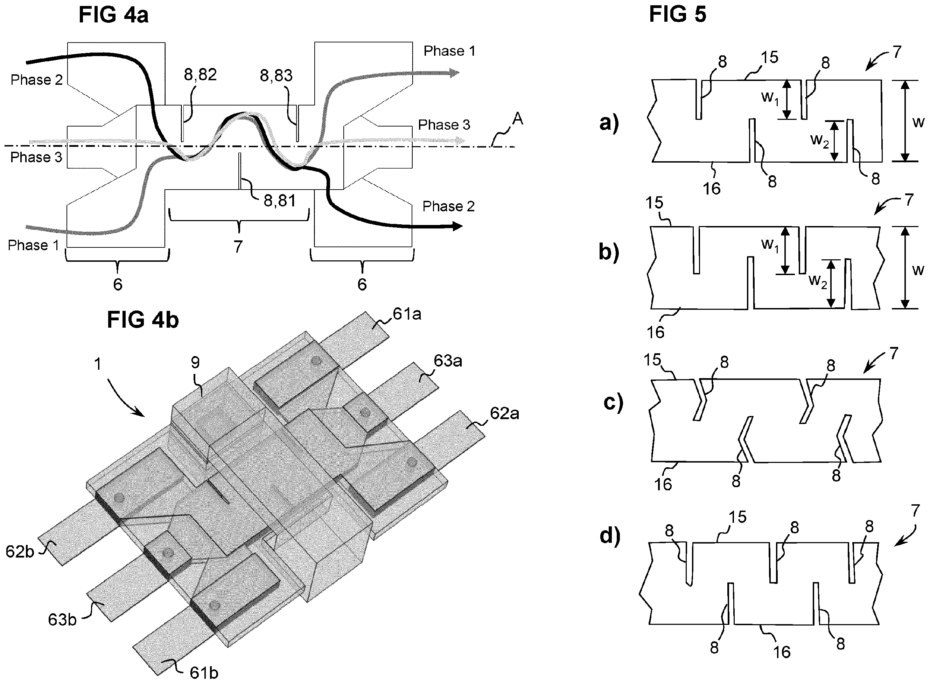

Referring in particular to figures 3a to 3c and 4a and 4b, according to a first aspect of the invention, each of the primary conductors 2a, 2b, 2c has respective connection terminals 61a, 61b, 62a, 62b, 63a, 63b that are in a non-overlapping relationship, interconnected to respective center sections 7a, 7b, 7c that are in a stacked overlapping relationship, the center sections 7a, 7b, 7c extending through the primary conductor passage 10 and surrounded by the magnetic core 3.

A first primary conductor 2a has a first connection terminal 61a arranged at a certain distance from a center line A of the center sections extending through the primary conductor passage 10, and a second connection terminal 61b arranged at a certain distance from the center line but on an opposite side of the center line from the first connection terminal. The first primary conductor 2b thus extends from one side of the center line to the other side of the center line. A second stacked primary conductor 2b has a form similar to the first primary conductor 2a but in mirror image symmetry such that it has a first connection terminal 62a is arranged at a certain distance from the primary conductor center line ***A,*** and a second connection terminal 62b is arranged at a certain distance from the center line but on an opposite side of the center line from the first connection terminal 62a, whereby the connection terminals of the second and third conductors are on opposed sides to each other. The second and third primary conductors thus form a general X-shape.

In a three phase conductor system, a third primary conductor 2c may extend in a substantially straight manner parallel and aligned along the primary conductor center line ***A.***

The center sections 7a, 7b and 7c of the plurality of conductors - in the illustrated embodiment the first, second and third conductors - are aligned with the centerline ***A*** and overlapping with each other.

The crossing over of the center line by the first and second primary conductors, with a third primary conductor remaining on the center line, has the effect of increasing the Common Mode Rejection and thus reducing the common mode signals affecting the leakage measurement.

Referring more particularly to figures 4a and 4b, according to a second aspect of the invention the primary conductors 2a, 2b, 2c comprise transverse slots 8 extending into the center sections 7a, 7b, 7c from outer lateral side edges 15, 16 of the center sections.

In the embodiment illustrated in figure 4a, 4b, there are three slots 8, a first centrally positioned slot 8 extending from a first lateral side 15 of the center section 7, and second and third slots 8 extending from an opposite second lateral side 16 of the center section 7 of the primary conductor, the slots 8 spaced apart from each other in a direction of the primary conductor centerline ***A.***

The slots 8 create a weaving current flow path through the center sections 7 of each conductor, that has the effect of generating magnetic fields through the center passage 10 that increase common mode rejection and thus improve the leakage measurement of the current transducer by reducing the common mode effects on the stacked primary conductors 2.

The length W1, W2 of the slots extending from the lateral edges 15, 16 are preferably equal to at least 40% the width ***W*** between the lateral edges 15, 16 of the primary conductor sections 7, preferably in a range of 50 to 70%, to ensure that the primary currents weave through the center sections 7a, 7b, 7c.

In the illustrated embodiment, the slots 8 of different primary conductors 2a, 2b, 2c are preferably identical and overlap each other in a stacked manner, however within the scope of the invention it is possible to provide the different primary conductors with slots that do not align in a stacked manner above each other. It is moreover possible to have only some of the slots that align from different primary conductors and to have the middle or center primary conductor 2b that extends in a substantially straight line to be provided without any slots and only have the primary conductors stacked above and below the middle primary conductor with slots.

In variants, for instance as illustrated schematically in figure 5, variants a) to d), there may be provided a greater number of slots 8 that are arranged in the center section 7, to create more turns in the meandering primary conductor flow path. For instance, there may be two slots extending from the first lateral side and two slots extending from the second lateral side offset with respect to each other, or there may be three slots extending a first lateral side and two slots from a second lateral side. In a variant (not shown), it is also possible to have only two slots, one on each side for creating a meandering primary conductor current flow path.

The slots may also be straight, or have a bent shape, and it is possible for the slots to have different lengths

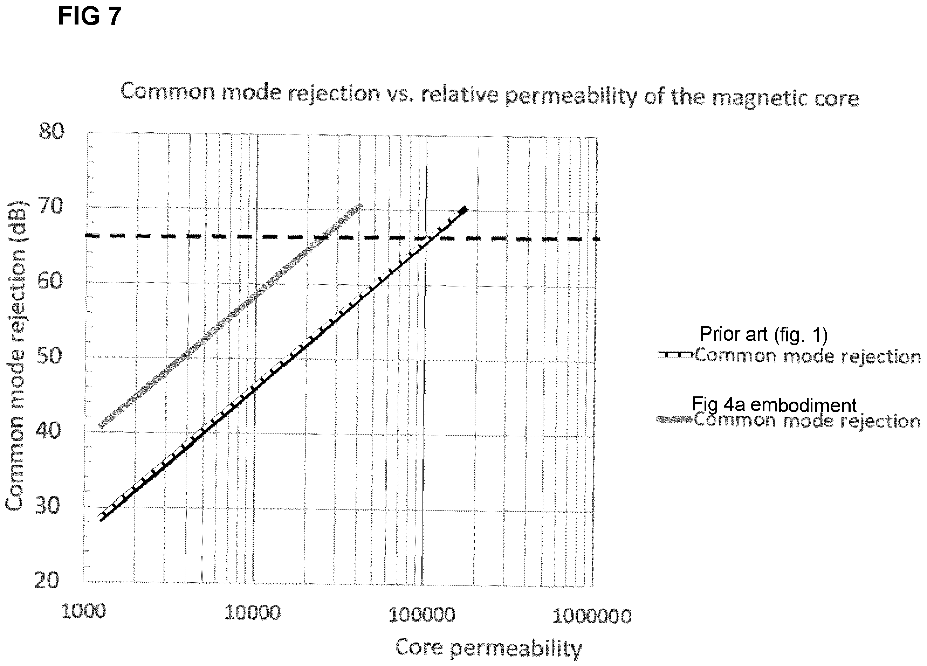

Figure 7 illustrates the improvement in dB of a three-phase primary conductor arrangement according to figure 1a (prior art) and a three-phase primary conductor arrangement of a current transducer according to an embodiment of the invention with the configuration of figures 4a and 4b showing a marked improvement of common mode rejection.

### List of references

Current transducer 1
   **Primary conductors 2, 2a, 2b, 2c**
      Connection terminals 6, 61a, 61b, 62a, 62b, 63a, 63b
         First end
         Second end
      Centre section 7, 7a, 7b, 7c
         Slots 8
         First lateral side edge 15
         Second lateral side edge 16
   **Magnetic core 3**
      Primary conductor passage 10
      Branches 11a, 11b, 11c
         Open end extensions 12
      Air gap 13
   **Magnetic field sensor 4**
      Connection terminals 14
   **Circuit board 5**
      Orifice 17 (for mounting of magnetic field sensor)
   **Housing 9**
      Base 9a
      Cover 9b
Primary conductor centreline ***A***

## Claims

1. A current transducer (1) for measuring a residual current, comprising a plurality of primary conductors (2, 2a, 2b, 2c), a magnetic core (3) having at least one air gap (13), at least one field sensor (4) positioned within said at least one air gap (13), and a housing (9) enclosing at least a portion of the primary conductors, magnetic core and magnetic field sensor, each primary conductor extending between first and second connection terminals (61a, 61b, 62a, 62b, 63a, 63b) and having a center section (7a, 7b, 7c) interconnecting the first and second connection terminals, the center section extending through a primary conductor passage (10) surrounded by the magnetic core (3), center sections of the primary conductors arranged in an overlapping stacked relationship separated by insulating layers, the center sections extending along a primary conductor center line **(*A*)** extending through the primary conductor passage (10), **characterized in that** at least a first primary conductor of said plurality of primary conductors comprises a first connection terminal (61a) positioned at a non-null distance from said center line **(*A*)** and the second connection terminal (61b) thereof being positioned at a non-null distance from said center line **(*A*)** on a second side of the center line opposite the first side of the center line, and at least a second primary conductor of said plurality of primary conductors having said first connection terminals (63a) separated from the center line at a non-null distance on said second side and having a second said connection terminal (63b) separated from the center line by a non-null distance on the first side of the center line.

2. The current transducer according to claim 1 further comprising a third primary conductor (2c) of said plurality of primary conductors, said third primary conductor having said first and second connection terminals (63a, 63b) and said center section (7b) forming a straight primary conductor aligned and centered on the center line **(*A*).**

3. The current transducer according to any preceding claim wherein there are only three primary conductors for connection to a three-phase conduction system.

4. The current transducer according to any preceding claim wherein at least said first and second primary conductors comprise a plurality of slots (8) comprising at least a first slot extending into the center sections from a first lateral side (15) of the center sections, and at least a second slot extending into the center sections from a second lateral side (16) of the center section opposed to the first lateral side, arranged such that a primary current flowing between the first and second connection terminals of said at least first and second primary conductors flows through the center sections in a meandering path.

5. The current transducer according to the preceding claim wherein there is at least a third slot extending from the first lateral side of the center section transversally into the center section, the first and third slots arranged in a spaced apart relationship from the first slot.

6. The current transducer according to the preceding claim wherein there are three said slots, two extending transversely from the first lateral side and one extending transversely from the second lateral side, positioned substantially centrally between the first and third slots.

7. The current transducer according to the preceding claim wherein the slots extend from the respective lateral side along a length (W1, W2) in a range of 40% to 70% of a width (W) of the primary conductor center section (7) between the first lateral side (15) to the second opposed lateral side (16).

8. The current transducer according to any preceding claim wherein the slots are substantially thin straight slits.

9. The current transducer according to any preceding claim wherein at least said first and second primary conductors comprising slots have said slots arranged in a stacked overlapping and aligned relationship.

10. The current transducer according to any preceding claim further comprising a circuit board (5), the magnetic field sensor (4) being electrically connected to secondary conductor tracks on said circuit board, and the primary conductors provided as conductive circuit traces on different layers of the circuit board.

11. The current transducer according to the preceding claim wherein the magnetic field sensor (4) is provided in the form of an ASIC chip, the ASIC chip mounted within an orifice formed through the circuit board, or with a major surface of the ASIC chip mounted flat against an outer surface of the circuit board.

12. The current transducer according to either of the two directly preceding claims wherein the connection terminals (6) of the primary conductors and connection terminals (14) on the circuit board connected to the magnetic field sensor, are in the form of conductive pads or plated through-holes formed on the circuit board for connection to conductors of an external circuit.

13. The current transducer according to any of the preceding claims wherein the housing (9) comprises a base (9a) and a cover (9b) assembled around the magnetic core (3), magnetic field sensor (4) and a portion of the primary conductors, the base (9a) and cover (9b) being assembled together on opposite sides of the circuit board (5).

14. The current transducer according to any preceding claim in combination with claim 10, wherein the magnetic core is in the form of a flat strip of soft magnetic material bent around to form the magnetic circuit, the ends of the magnetic core strip forming open end extensions (12) bent from an end branch of the magnetic core such that the open end extensions (12) are arranged parallel to the circuit board and are mounted against opposite sides of the circuit board.

15. The current transducer according to any preceding claim wherein the magnetic core is in the form of a flat strip of soft magnetic material bent around to form the magnetic circuit, the strip of soft magnetic material having a thickness *T* to width *W* ratio *T*/*W* less than 0.3, preferably less than 0.2, and greater than 0.1, the width being measured in a direction orthogonal to the primary conductor center line (***A***)*.*
